# EUROPEAN PATENT APPLICATION

(11) **EP 2 879 165 A1**
(43) Date of publication of application: **03.06.2015**
(21) Application number: 13194774.9
(22) Date of filing: 28.11.2013
(51) Int. Cl.: H01L 21/3065, C23C 16/44, C23F 1/00

(54) **Etching Process**

(71) Applicant: Solvay SA, 1120 Bruxelles (BE)
(72) Inventor: The designation of the inventor has not yet been filed
(74) Representative: Mross, Stefan P.M.

(57) **Abstract**

Processes for the manufacture of devices including microelectromechanical systems comprising a step in which a substrate is etched using an etching agent prepared from SF₄ are disclosed.

## Description

The present invention relates to a method for the manufacture of a device comprising a step in which a substrate is etched using an etching agent prepared from a SF₄-containing mixture.

NF₃ and SF₆ are often used in dry etching steps in the production of devices like semiconductors, solar cells and/or microelectromechanical systems (MEMS). NF₃ and SF₆ can be used to etch inorganic coatings like SiON, amorphous Si, SiO₂, TiN, TaN or W. For example, WO 88/08930 discloses a process for etching deep trenches into silicon using NF₃ and SF₆.

However, both NF₃ and SF₆ show a relatively high Global Warming Potential (GWP).

Now therefore, the invention makes available an improved process for the manufacture of the aforementioned and other devices. It is an objective of the present invention to provide a process which is more ecological, e.g. by using a gas mixture with an improved GWP. It is a further objective to provide a process which is more economical, e.g. by using a gas mixture comprising cheaper components and/or by enabling the use of less complex equipment. It is a further objective to provide a process with improved etching characteristics, e.g. by an improved anisotropy, an improved etching selectivity and/or by an improved etching rate.

These and other objects of the present invention are achieved by the process according to the claims.

In a first embodiment the invention concerns a process for the manufacture of a device comprising at least one etching step wherein an inorganic material is etched using an etching agent which is generated in a transformation step starting from a gas mixture comprising, consisting of or essentially consisting of SF_{4.}

The term "consists essentially of" is intended to denote that the gas mixture consists of SF₄ as well as optionally trace amounts of further components, e.g. impurities, wherein the optional further components do not alter the essential characteristics of the gas mixture. The term "gas mixture" also encompasses SF₄ as such without the presence of another component in the gas mixture. In an alternative embodiment, SOF₂ is used instead of SF₄ or a mixture of SOF₂ and F₄ is used. SOF₂ has a further advantage of being a fluorine-bearing as well as an oxygen-bearing gas. In another alternative embodiment, SOF₄ is used instead of SF₄, a mixture of SOF₄ and SF₄ or a mixture of SOF₄, SOF₂ and SF₄ is used. SOF₄ also has the further advantage of being a fluorine-bearing as well as an oxygen-bearing gas.

Preferably, the device is selected from the list consisting of a semiconductor material, a solar panel, a flat panel, or a microelectromechanical system (MEMS). Preferably, the device is a microelectromechanical system.

MEMS are very small devices, generally ranging in the size from a micrometer to a millimeter. Common applications include inkjet printers operating with piezoelectrics or thermal bubble ejection, accelerometers in cars, e.g. for airbag deployment in collisions, gyroscopes, silicon pressure sensors e.g. for monitoring car tires or blood pressure, optical switching technology or bio-MEMS applications in medical and health-related technologies. Microelectronic circuits process the information gathered by sensors from the environment through measuring mechanical, thermal, biological, chemical, optical or magnetic phenomena.

Devices like semiconductor materials, solar panels, flat panels, or microelectromechanical systems are usually manufactured using a dry etching step, i.e. a step involving the removal of material using an etching agent. The term "etching agent" is intended to denote the active agent which is involved in this etching step by chemically reacting with the inorganic material to be etched. This etching agent usually comprises ions, i.e. the etching agent is a plasma, and it can be prepared by transformation of a gas mixture for example by thermal transformation or by radio frequency discharge. If the etching agent is generated thermally, the temperature during the transformation step is equal to or higher than 200°C, and equal to or lower than 500°C.

The dry etching hardware generally involves a vacuum chamber, a special gas delivery system, and an exhaust system and in case of a plasma generated by radiofrequency discharge, a radiofrequency generator. Said radiofrequency generator is preferably located outside of the vacuum chamber to allow for longer lifetime of the equipment involved. The process is best performed using the Bosch process which may be carried out in plasma etchers available from Alcatel, Advanced Materials, Plasma-Therm or Surface Technology Systems. The plasma is generated by a magnetron or microwave irradiation.

One advantage of SF₄ over SF₆ and NF₃ is that a plasma can be generated under thermal conditions, i.e. without the use of a radiofrequency generator.

Accordingly, the transformation step is preferably a thermal transformation step or a radiofrequency discharge transformation step, more preferably a remote-source radiofrequency discharge step.

SF₄ can be applied in the gas mixture as such, i.e. without diluent or additional compounds. Preferably, the concentration of the SF₄ in the gas mixture is ≥10 Vol %, preferably ≥ 35 Vol %, more preferably ≥ 50 Vol % and most preferably ≥ 90 Vol %. It is also preferred to apply it diluted by an inert gas and/or in the presence of oxygen or an oxygen-bearing gas and/or in the presence of gases or vapors which have a passivating effect. Preferred inert gases are selected from the group consisting of N₂, Ar, Xe, He and Ne, more preferably N₂. Further, additives like hydrogen or passivating gases can also be added. Also preferably, the gas mixture comprises SF₄ and at least one further gas selected from the group consisting of an inert gas and an oxygen-bearing gas.

The term "oxygen-bearing gas" is intended to denote a gas the chemical structure of which contains an oxygen atom. Preferred oxygen-bearing gases are selected from the group consisting of O₂, O₃, N₂O, CO₂, CO and SO₂, more preferably the oxygen-bearing gas is O₂. Amongst other roles, the oxygen-bearing gas can have the role to oxidize certain other compounds, e.g. the SF₄ and/or other sulphur-containing compounds. Some of these other compounds might be converted into volatile components by this oxidation process.

Most preferably, the gas mixture used in the process is a ternary gas mixture comprising SF₄, an oxygen-bearing gas and an inert gas, preferably the gas mixture consists of or essentially consists of SF₄, Ar and O₂.

The process for the manufacture of the MEMS may involve a step of anisotropic and isotropic etching. In anisotropic etching, the etching gas forms a trench by etching the bottom of the trench without or nearly without affecting the side walls. If isotropic etching is desired, prevention of side wall etching is not necessary. In anisotropic etching, side wall etching is undesired. A preferred method of anisotropic etching is performed by either including a passivating gas into the etching gas wherein the passivating gas protects the side walls, or by sequential etching with the etching agent and in a separate step, forming a passivating layer on the side walls using a passivating gas.

The passivating gas is applied to form a protective layer on the trench walls to prevent them to react with the etching agent. The nature of the passivating gas depends on the kind of structure. For silicon as structure, bromine sources, for example elemental bromine or HBr can be applied as passivating gas. A layer of non-volatile Si_{X}Br_{Y} compounds is formed as a protective layer. Other sources forming a protective layer with silicon are CS₂ or a combination of SiCl₄ and N₂. The passivating gas is preferably selected from cyclic, linear or branched saturated aliphatic compounds with 1 to 6 carbon atoms, substituted by at least one fluorine atom, or from cyclic, linear or branched unsaturated aliphatic compounds with 2 to 6 carbon atoms, substituted by at least one fluorine atom. These compounds consist of carbon and fluorine and optionally hydrogen. Preferably, at least 50 % of the hydrogen atoms of the respective saturated or unsaturated compound are substituted by fluorine atoms. Saturated hydrofluorocarbons and saturated fluorocarbons with 1 to 6 carbon atoms and unsaturated hydrofluorocarbons and unsaturated fluorocarbons with 2 to 6 carbon atoms are preferred. Highly preferred compounds which are applicable as passivating gas are c-C₄F₆, c-C₅F₈, CH₂F₂, CHF₃, CF₄, C₂F₆, C₃F₈, C₂F₄, C₄F₆, and C₄F₈. The compounds c-C₆F₆ and CF₃I are also suitable. C₄F₆ is especially preferred as passivating gas. The expert knows that some of the suitable compounds have a boiling point which is higher than 20°C at normal pressure and is aware that for these compounds, the term "gas" should be understood to mean "vapor". These compounds are suitable even if not gaseous at 20°C because the process of the present invention is performed at a pressure low enough for these compounds to be no longer liquids but in the form of a vapor.

Preferred gas mixtures for passivation only (with low or no anisotropic etching effect) in MEMS preparation include one or more of the above-mentioned aliphatic cyclic, linear or branched fluorocarbons or hydrofluorocarbons with 1 to 6 carbon atoms (saturated) or 2 to 6 carbon atoms (unsaturated). Optionally, a hydrogen or a hydrogen-releasing gas (a gas that releases hydrogen under thermal conditions, especially at temperatures at or higher than 200°C, or in a plasma), preferably difluoromethane or trifluoromethane, is also present, especially, if perfluorinated compounds are applied as passivating gas. If hydrogen or a hydrogen-releasing gas is present, it is preferably comprised in an amount of 1 to 5 Vol %. Also, it is possible to include argon for improving the plasma.

The process for MEMS etching can principally be performed in two alternatives : the structure is treated with the etching agent and the passivating gas simultaneously, or treatment with the etching agent is performed in one step, and treatment with the passivating gas is performed in another step; the second alternative wherein etching and passivation are consecutively performed is called "Bosch" process. The "Bosch"-type process is preferred.

If desired, after forming the trench by etching and passivation, an additional step (or multitude of steps) can be performed to achieve underetching, as described in GB 2 290 413. In this step, it is preferred only to apply the etching agent.

The etching step is performed on a structure that later forms part of the device or the structure itself constitutes said device.

The temperature of the structure during plasma treatment will generally be kept in a range from 20°C to 100°C, but it may be higher. The pressure during the plasma treatment is preferably from 1.5 · 10⁻² mbar to 15 mbar. Preferably, the pressure is equal to or greater than 1 · 10⁻¹ mbar. It is preferably equal to or lower than 1.5 mbar.

While the structure may have variable forms, it is preferably in the shape of a wafer. The structure is generally made from an inorganic material. Preferably, the inorganic material is Si, SiOₓN_{y}, SiO₂, TaN, TiN or W, more preferably it is amorphous Si. Most preferably, the structure used in the etching step is a silicon wafer.

The etching can be performed according to the bulk micromachining technology wherein the whole thickness of the item to be etched, e.g. a silicon wafer, is used to build the micromechanical structure. Alternatively, the etching can be performed according to the surface micromachining technology wherein layers are produced by applying coatings and selective etching of them. The etching process can generally be used in the deep reactive ion etching technology.

The process according to the present invention can be applied to produce semiconductors for microelectromechanical systems, for example, acceleration sensors, magnetic recording heads, ink jet printers, gyroscopes and other items as described above.

One advantage of the process according to the present invention is that NF₃ and/or SF₆ can be substituted by a gas mixture which is environmentally friendly in view of GWP. It has been found that the gas mixtures in the process according to the present invention are, for many applications, comparable and sometimes better than the conventional etching or cleaning processes using NF₃ and/or SF₆. A further advantage of the process is that the gas mixtures according to the present invention can be used as drop-in substitutes for the respective conventional mixtures. Accordingly, another embodiment of the present invention concerns a process wherein the gas mixtures comprising or consisting of SF₄ are used as a drop-in substitute for gas mixtures comprising NF₃ and/or SF₆, preferably under substantially the same conditions.

Another aspect of the present invention concerns the use of a gas mixture comprising, consisting of or essentially consisting of SF₄ for the preparation of an etching agent used in the manufacture of a device, preferably the etching agent is prepared in a thermal transformation step or a radiofrequency discharge transformation step starting from the gas mixture. Also preferably, the device is selected from the list consisting of a semiconductor material, a solar panel, a flat panel, or a microelectromechanical system, preferably the device is a microelectromechanical system.

Yet another aspect of the present invention concerns a gas mixture comprising, consisting of or essentially consisting of SF₄, Ar and O₂.

During operation of the vacuum chamber, depositions can occur on the inside walls of the vacuum chamber. Regular removal of such deposits is desirable to obtain stable and repeatable deposition results with uniform surfaces at acceptable particle levels. This process is known under the name "chamber cleaning". The inventive gas mixture can also be used to clean the vacuum chamber of such unwanted deposits. Accordingly, still another aspect of the present invention concerns the use of a gas mixture comprising, consisting of or essentially consisting of SF₄ for chamber cleaning.

The following examples shall explain the invention in further detail, but they are not intended to limit the scope of the invention.

### Examples :

### Example 1 : Etching of structures of different materials :

### Used apparatus :

Experiments are performed in a custom-made stainless steel vacuum chamber (26 liters volume) with an attached remote Astron Astex plasma source, made by MKS Astron, operated at 13.56 MHz, located 32 cm above the sample. The chamber is evacuated with a turbo molecular pump and a BOC Edwards dry pump. The exhaust gases are analyzed by mass spectroscopy; a differentially pumped Leybold-Inficon Transpector 200 amu unit is used. The structure to be etched is placed on a chuck in the center of the reactor chamber. The temperature in the chamber is controlled and can be varied between room temperature (around 20°C) and 300°C.

The remote plasma source is usually ignited in the presence of pure argon. Directly after the plasma is in a stable condition, the gas mixture comprising SF₄ is introduced.

### Determination of etch rates :

The etch rates was determined in situ by reflectrometry using a 645 nm laser directed to the sample. The etch rate is calculated by dividing the thickness of the film by the time when the removal endpoint was detected.

### Reparation of the mixture :

The individual components are filled in their corresponding ratios into a pressure vessel, thereby forming a homogeneous mixture of the compounds.

### Structures to be etched :

The size of the samples is 20×20 mm. The investigated material is deposited on a 150 nm thermal SiO₂ layer to allow interferometric measurement. The SiON and SiO₂ samples are deposited on bulk silicon since their optical properties allow interferometric measurements.

The following structures are used :
a) 1000 nm SiOₓN_{y} (referred to as SiON) on bulk silicon, deposited by a conventional TEOS/ozone CVD process
b) 1000 nm SiO₂, thermally grown on bulk silicon
c) 300 nm tungsten, deposited by a conventional PVD process
d) 300 nm TiN, deposited by a conventional PVD process
e) 200 nm TaN, deposited by a conventional PVD process

### Example 2 : MEMS production

### Mixtures suitable for etching silicon in MEMS production

General procedure : the different constituents are passed in gaseous form from respective storing bottles to a stainless steel container stored therein in gaseous form. By controlling the volume during storing the respective gases, gas mixtures comprising the appropriate amounts of gases given in table 1 are prepared.

**Table 1 : Gas mixtures (amounts given in % by volume)**

| Example | SF₄ | N₂ | Ar | O₂ |
|---|---|---|---|---|
| 1.1 | 95 | -- | -- | 5 |
| 1.2 | 85 | -- | 10 | 5 |
| 1.3 | 45 | 45 | -- | 10 |
| 1.4 | 85 | -- | 5 | 10 |

**Table 2 : Passivating gas mixtures (amounts given in % by volume)**

| Example | C₄F₆ | Ar | H₂ | CHF₃ |
|---|---|---|---|---|
| 1.5 | 60 | 40 | -- | -- |
| 1.6 | 50 | 40 | -- | 10 |
| 1.7 | 50 | 40 | 10 | -- |
| 1.8 | 40 | 40 | 10 | 10 |

**Table 3 : Gas mixtures suitable for simultaneous etching and passivating (amounts given in % by volume)**

| Example | SF₄ | Passivating agent | Ar | Other |
|---|---|---|---|---|
| 2.1 | 35 | C₄F₆¹⁾:35 | 30 | -- |
| 2.2 | 40 | C₄F₆¹⁾: 20 | 30 | CHF₃:10 |
| 2.3 | 40 | C₄F₆¹⁾: 20 | 30 | H₂: 10 |
| 2.4 | 25 | C₃F₈: 40 | 30 | F₂: 5 |

| | | | | |
|---|---|---|---|---|
| ¹⁾ Hexafluorobutadiene, available as Sifren® from Solvay Fluor GmbH, Hannover, Germany | | | | |

### Reparation of a MEMS device by consecutive etching and passivating (bulk micromachining)

A silicon wafer for a MEMS device is coated with a photo resist lacquer. After partial exposure of the photo resist lacquer with light according to the desired structure including desired trenches, non-exposed parts of the lacquer are removed. The silicon wafer is then put into a plasma chamber. A gas mixture according to example 1.1 is introduced into the chamber at a pressure of about 0.2 mbar, and the microwave radiation is started to initiate plasma conditions. Silicon in regions not covered by the photo resist is etched away isotropically whereby a trench forms in the silicon. After a trench with a width of about 20 µm is formed, the etching agent is removed from the reactor, and a passivation gas according to example 1.5 is introduced into the reactor, and the microwave radiation is started to initiate the plasma. The hexafluorobutadiene introduced into the reactor essentially forms a fluoropolymer coating on the walls of the trenches formed in the silicon, while the argon stabilizes the plasma. After a coating with desired thickness has formed on the walls, the passivating gas is removed, and fresh etching gas is re-introduced into the reactor. The silicon layer is then again isotropically etched, thereby deepening the trench formed in the first etching step. The passivating layer protects the wall of the trench. When the desired additional depth of the trench is achieved, etching is terminated and the etching agent is removed from the plasma reactor. Once again, passivating gas is introduced, and another passivating step is performed. Thereafter, the passivating gas is removed, and the anisotropic etching is continued. Etching and passivation are consecutively performed until a trench with desired depth has formed. The etched wafer can be removed from the chamber.

### Reparation of a MEMS device by simultaneous etching and passivating (bulk micromachining)

A silicon wafer is coated with a dielectric layer of silicon dioxide which, in turn, is coated with a photo resist lacquer. After partial exposure of the photo resist lacquer with light according to the desired structure including desired trenches, non-exposed parts of the lacquer are removed. The silicon wafer is then put into a plasma chamber. A gas mixture according to example 2.1 is introduced into the chamber at a pressure of about 0.2 mbar, and the microwave radiation is started to initiate plasma conditions. Silicon dioxide in regions not covered by the photo resist is etched away. During etching, a trench forms. Simultaneously, a fluoropolymer passivation layer is formed on the walls of the trench. The treatment is continued until the trench has the desired depth. The etching agent and passivating gas are removed from the reactor, and the etched silicon wafer can be removed from the chamber.

## Claims

1. A process for the manufacture of a device comprising at least one step wherein an inorganic material is etched using an etching agent which is generated in a transformation step starting from a gas mixture comprising, consisting of or essentially consisting of SF₄.

2. The process according to claim 1 wherein the device is selected from the list consisting of a semiconductor material, a solar panel, a flat panel, or a microelectromechanical system, preferably the device is a microelectromechanical system.

3. The process according to claim 1 or 2 wherein the etching agent is generated in a thermal transformation step or a radio frequency discharge transformation step, preferably a remote-source radio frequency discharge transformation step.

4. The process according to any one of claims 1 to 3 wherein the concentration of the SF₄ in the gas mixture is ≥10 Vol %, preferably ≥ 35 Vol %, more preferably ≥ 50 Vol % and most preferably ≥ 90 Vol %.

5. The process according to any one of claims 1 to 4 wherein the gas mixture comprises SF₄ and at least one further gas selected from the group consisting of an inert gas and an oxygen-bearing gas.

6. The process according to claim 5 wherein the inert gas is selected form the group consisting of N₂, Ar, Xe, He and Ne.

7. The process according to claim 5 wherein the oxygen-bearing gas is selected from the group consisting of O₂, O₃, N₂O, CO₂, CO and SO₂, preferably the oxygen-bearing gas is O₂.

8. The process according to any one of claims 1 to 7 wherein the gas mixture is a ternary gas mixture comprising an oxygen-bearing gas and an inert gas, preferably the gas mixture consists of or essentially consists of SF₄, Ar and O₂.

9. The process according to any one of claims 1 to 8 wherein the inorganic material is Si, SiOₓN_{y}, SiO₂, TaN, TiN or W.

10. The process according to any one of claims 1 to 9 wherein the gas mixture is used as a drop-in substitute for gas mixtures comprising NF₃ and/or SF₆, preferably under substantially the same conditions.

11. Use of a gas mixture comprising, consisting of or essentially consisting of SF₄ for the preparation of an etching agent used in the manufacture of a device.

12. The use according to claim 11 wherein the etching agent is prepared in a thermal transformation step or a radiofrequency discharge transformation step starting from the gas mixture.

13. The use according to claim 11 or 12 wherein the device is selected from the list consisting of a semiconductor material, a solar panel, a flat panel, or a microelectromechanical system, preferably the device is a microelectromechanical system.

14. A gas mixture comprising, consisting of or essentially consisting of SF₄, Ar and O₂.

15. Use of a gas mixture comprising, consisting of or essentially consisting of SF₄ for chamber cleaning.
